# EUROPÄISCHE PATENTSCHRIFT

(11) **EP 2 545 564 B1**
(45) Veröffentlichungstag und Bekanntmachung des Hinweises auf die Patenterteilung: **24.12.2014**
(21) Anmeldenummer: 11710420.8
(22) Anmeldetag: 28.02.2011
(51) Int. Cl.: H01L 41/12

(54) **AKTUATOR**
ACTUATOR
ACTIONNEUR

(30) Priorität: 09.03.2010 DE 102010010801
(43) Veröffentlichungstag der Anmeldung: 16.01.2013
(73) Patentinhaber: Eto Magnetic GmbH, 78333 Stockach (DE)
(72) Erfinder: LAUFENBERG, Markus, 78333 Stockach (DE); THODE, Oliver, 78333 Stockach - Wahlwies (DE)
(74) Vertreter: Behrmann, Niels
(86) Internationale Anmeldenummer: PCT/EP2011/000959
(87) Internationale Veröffentlichungsnummer: WO 2011/110293

(56) Entgegenhaltungen:
- DE-A1-102004 060 532
- DE-A1-102005 038 891
- GB-A- 2 445 773
- US-A1- 2003 057 394

## Beschreibung

Die vorliegende Erfindung betrifft einen Aktuator mit einem als Reaktion auf eine elektrische Ansteuerung einer Spulenvorrichtung antreibbaren Antriebselement aus magnetischem Formgedächtnismaterial nach dem Oberbegriff des Hauptanspruchs. Eine solche vorrichtung ist aus der DE 102 004 060 532 A1 bekannt.

Derartige Vorrichtungen sind aus dem Stand der Technik bekannt und nutzen den Effekt aus, dass unter Einfluss eines Magnetfeldes sogenannte Formgedächtnismaterialien (auch häufig genannt: Formgedächtnislegierungen, MSMA) eine Expansionsbewegung durchführen, welche typischerweise im niedrigen einstelligen Prozentbereich bezogen auf eine Länge des Elements entlang der Expansionsrichtung (= Antriebsrichtung) liegt.

Bei derartigen Vorrichtungen besteht eine prinzipielle Anforderung darin, dass das die Dehnung bzw. die Längenänderung des Antriebselements bewirkende Magnetfeld senkrecht zu der Ausdehnungs- bzw. Antriebsrichtung ("Wirkachse") stehen muss. Entsprechend bedeutet das für elektromagnetische Spulenvorrichtungen, welche das notwendige Magnetfeld erzeugen, dass diese (etwa bei einem Spulenpaar) mit ihrer Symmetrieachse senkrecht zur Arbeitsrichtung des Aktuators stehen müssen. Dies führt zu (häufig nachteiligen) großen Bauräumen, insbesondere, wenn zwei Spulen symmetrisch beidseitig des Formgedächtniselements vorgesehen sind.

Aus dem Stand der Technik ist es daher bekannt, Antriebselemente aus einem magnetischen Formgedächtnismaterial an verschiedenen Stellen entlang eines magnetischen Kreises einzusetzen (etwa in einem zwischen Gehäuseelementen eines magnetisch leitenden Gehäuses gebildeten Spalt), was jedoch zu mechanisch umständlichen bzw. geometrisch und konstruktiv aufwändigen Realisierungen führt, welche zudem nicht optimal mechanische Antriebsenergien bereitstellen.

Insbesondere ermöglicht keine der bekannten Realisierungsformen zum Beaufschlagen eines magnetischen Formgedächtnismaterials zur Realisierung eines Aktors das Nutzen gängiger Baugruppen und Komponenten, wie sie etwa aus herkömmlichen elektromagnetischen Aktorrealisierungen bekannt sind, nämlich langgestreckte, axial verlaufende Ankerstößel, welche von einer typischerweise zylindrischen Spule umgeben sind (und für welche Einbauräume, etwa im Kraftfahrzeug, typischerweise dimensioniert sind).

Aufgabe der vorliegenden Erfindung ist es daher, eine Aktorvorrichtung mit einem Antriebselement aus magnetischem Formgedächtnis(Legierungs)-Material nach dem Oberbegriff des Hauptanspruchs so zu verbessern und weiter zu entwickeln, dass eine vereinfachte magnetisch-konstruktive Realisierung entsteht, insbesondere kompakte Abmessungen der Aktorvorrichtung erreicht werden können und die mechanische Antriebsenergie des Antriebselements auf einfache Weise an einen Stellpartner, etwa einen Stößel od. dgl., übertragen werden kann.

Die Aufgabe wird durch den Aktuator (Aktor) mit den Merkmalen des Hauptanspruchs gelöst. Vorteilhafte Weiterbildungen der Erfindung sind in den Unteransprüchen beschrieben.

In erfindungsgemäß vorteilhafter Weise ist der aus magnetischem Formgedächtnismaterial realisierten und in ansonsten bekannter Weise mit einem Stellpartner, etwa einem langgestreckten Stößel oder einem Ventilteil, zusammenwirkenden Expansionseinheit ein Paar von Flussleitelementen seitlich benachbart (und bevorzugt kontaktierend) so zugeordnet, dass die Flussleitelemente die Expansionseinheit zwischen sich aufnehmen und im Flussleitbereich (Kontaktbereich) für eine Magnetflussführung durch die Expansionseinheit sorgen, die quer zur Antriebsrichtung verläuft, also im Hinblick auf die gewünschte Expansionswirkung unter Magnetfeldeinfluss geometrisch optimal ist. (Dabei ist der Begriff "quer" zur Antriebsrichtung nicht notwendigerweise als idealer rechter Winkel zu verstehen; in der Praxis hat es sich als ausreichend bzw. sinnvoll herausgestellt, lediglich eine signifikante vektorielle Querkomponente vorzusehen, so dass als "quer" im Rahmen der Erfindung auch ein Magnetflussverlauf - relativ zur Antriebsrichtung - verstanden werden kann, welcher in einem Winkelbereich von ca. 80° bis 100°, bevorzugt 85° bis 95°, verläuft).

Der Erfindung liegt damit der Gedanke zugrunde, mit Hilfe der Flussleitelemente einerseits den für die Aktorik optimalen Fluss durch das Formgedächtnismaterial sicherzustellen, andererseits die Voraussetzungen für eine äußerst kompakte Bauform der Gesamtanordnung zu schaffen, welche insbesondere die Möglichkeit bietet, die mechanische Struktur und Wirkungsweise einer bekannten elektromagnetischen Stellvorrichtung (axial bewegbarer Anker mit Stößel innerhalb einer mantelseitig gebildeten Spulenwicklung) nachzubilden.

So ist es gemäß der Erfindung vorgesehen und beansprucht die Spulenvorrichtung umlaufend um eine Längsachse auszubilden, wobei die Antriebsrichtung und Erstreckungsrichtung der Expansionseinheit entlang dieser Längsachse erfolgt. Besonders geeignet ist eine radial symmetrische Form, gleichwohl sind auch andere Querschnittsrealisierungen etwa der Spuleneinheit möglich (z.B. eine quadratische oder rechteckförmige Querschnittskontur, ggf. mit geeignet abgerundeten Ecken).

Gemäß dieser Eigenschaft der Erfindung verläuft daher die Arbeitsrichtung (Antriebsrichtung) der Expansionseinheit entlang dieser Spulen-Symmetrieachse (d.h. der gedachten, sich durch das Spuleninnere erstreckenden Achse). Eine solche Spulenanordnung, welche, vergleiche die Aufgabenstellung, günstig den bekannten Gehäuseformen entspricht, ist gleichwohl nicht ideal im Hinblick auf einen quer zur Antriebsrichtung verlaufenden Magnetfluss in der Expansionseinheit, so dass erfindungsgemäß vorteilhaft die in der beanspruchten Weise vorgesehenen Flussleitelemente eine entsprechende Flussführung bewirken.

Besonders vorteilhaft und wirkungsvoll zum Erreichen der erfindungsgemäßen Flussleitung ist es dabei, wenn mindestens eines der Flussleitelemente, bevorzugt beide des Paares von Flussleitelementen, sich axial bzw. in der Antriebsrichtung entlang der Länge der Expansionseinheit, nämlich entlang deren vollständiger Erstreckung, erstrecken. Dies hat dann die vorteilhafte Wirkung günstigen Flusseintrags in das Formgedächtnismaterial mit minimierten magnetischen Verlusten. Gleichzeitig lässt sich, gemäß weiter bevorzugter Realisierung der Erfindung als bevorzugtes Ausführungsbeispiel, durch geeignete Ausgestaltung der Flussleitelemente etwa in Form von Armen, Armsegmenten od. dgl., welche gleichermaßen in der Antriebsrichtung bzw. axialparallel verlaufen, diese Geometrie platzsparend (insbesondere im Hinblick auf eine Breitenausdehnung) realisieren.

Dabei ist prinzipiell eine beliebige Querschnittskontur der Flussleitelemente geeignet, günstig ist jedoch, wenn - zum Zusammenwirken mit einem typischerweise im Querschnitt recht- oder vieleckigen Formgedächtnismaterial als Expansionseinheit -- das Flussleitelement mindestens eine entsprechend plane Kontaktfläche ausbildet, um insoweit wiederum möglichst günstig und verlustarm die magnetische Flussankopplung zum Formgedächtnismaterial sicherzustellen. In einem weitgehend radial symmetrischen Kontext bietet es sich beispielhaft und bevorzugt an, die axial einander gegenüberstehenden Flussleitelemente, welche zwischen sich das Formgedächtnismaterial kontaktieren, querschnittlich zylinderabschnitts- bzw. zylindersegmentförmig auszubilden, wobei die entsprechend plane Seite dann den Kontakt zum Formgedächtnismaterial herstellt.

Dabei ist es einerseits von der Erfindung umfasst, ein oder zwei bügefförmige Flussleitteile vorzusehen, wobei sich insbesondere auch die vorgeschriebene Stanz- bzw. Biegetechnik zur Herstellung in großserientauglicher und günstiger Weise eignet.

Auch ist es im Rahmen der Erfindung nicht notwendig, die Flussleitelemente entlang ihrer Längserstreckung querschnittlich gleich bzw. konstant vorzusehen. Vielmehr gibt es zahlreiche (magnetfluss-beeinflussende) Varianten, wie etwa Absätze, Ausnehmungen, Abschrägungen und/oder zulaufende Abschnitte, um einen magnetischen Flussverlauf bzw. einen zugehörigen Eintrag in das Formgedächtnismaterial je nach einem gewünschten Einsatzzweck bzw. magnetischem Verhalten zu optimieren.

Alternativ ist es in der Realisierung (z.B. mittels Stanztechnologie aus geeignet stanzfähigem Blech) günstig und bevorzugt, die Flussleitelemente im Querschnitt rechteckig oder vieleckig (mit mehr als vier planen Seitenflächen) auszugestalten.

Im Hinblick auf eine Realisierung des magnetischen Kreises bestehen zur Ankopplung der Flussleitelemente (und damit zur Herstellung des Magnetflusses über das Formgedächtnismaterial) zahlreiche bevorzugte Möglichkeiten; so ist es beispielsweise günstig und bevorzugt, das Formgedächtnismaterial (in der axialen Richtung) beidseits zwischen armförmig (mit jeweils einem freien Ende) ausgebildeten Flussleitelementen zu realisieren, welche im jeweiligen freien Endbereich zwischen sich das Formgedächtnismaterial seitlich kontaktieren.

Insbesondere unter dem Gesichtspunkt einer Serientauglichkeit und optimierten automatisierten Fertigbarkeit bietet es sich an, die Flussleitelemente etwa durch Umspritzen mit einem Kunststoffmaterial (als nicht magnetisch leitendem Material) zu halten, wobei weiter bevorzugt dann aus diesem Kunststoffmaterial im Wege eines Spritzvorgangs gleichzeitig weitere Aktuatorkomponenten, etwa ein Spulenträger für die Spulenvorrichtung, realisiert sein können.

Gemäß einer bevorzugten Realisierungsform der Erfindung erfolgt eine Rückstellung des als Reaktion auf die Magnetfeldbeaufschlagung expandierten Formgedächtnismaterials durch Wirkung eines bevorzugt axial mit diesem zusammenwirkenden Rückstellelements, etwa realisiert durch einen Kraftspeicher (typischerweise eine Druckfeder). Alternativ ist auch ein Zusammenwirken mit einem zweiten Element aus Formgedächtnismaterial denkbar, welches, z.B. in umgekehrt-analoger Weise beschaltet, dann zum Zurückstellen des expandierten (ersten) Antriebselements angesteuert wird. Während es im Rahmen einfach fertigbarer und großserientauglicher Realisierungsformen der Erfindung am meisten gebräuchlich sein dürfte, ein zentrales Antriebselement aus dem magnetischen Formgedächtnismaterial mantelseitig beidseits zu kontaktieren, ist es gleichwohl von der vorliegenden Erfindung umfasst, das Antriebselement aus dem magnetischen Formgedächtnismaterial hohlzylindrisch auszugestalten und den Magnetfluss radial so in das Material einzubringen, dass einerseits eine äußere mantelseitige Kontaktierung durch ein erstes Flussleitelement erfolgt, andererseits eine innenseitige Kontaktierung, z.B. durch ein axial verlaufendes stiftförmiges Flussleitelement erfolgt, mit dem Ergebnis, dass querschnittlich ein radialer Flussverlauf durch ein scheibenförmiges Formgedächtniselement entsteht.

Im Ergebnis ermöglicht es die vorliegende Erfindung, in überraschend einfacher und eleganter Weise, die ansonsten bekannten mechanischen Expansionswirkungen von magnetischen Formgedächtnismaterialien zur Realisierung eines Aktuators zu nutzen, welcher konstruktiv einfach ist, eine sehr kompakte Bauform ermöglicht und insbesondere keine erhöhte Breitenausdehnung, etwa gegenüber traditionell bekannten zylindrischen elektromagnetischen Stellvorrichtungen, zeigt. Entsprechend bietet damit die durch die vorliegende Erfindung realisierte Aktuatorvorrichtung die Möglichkeit, vorhandene Einbauräume zu nutzen und damit potentiell der magnetisch induzierten Aktuatortechnologie auf der Basis von Formgedächtnismaterialien völlig neue Einsatzfelder zu ermöglichen.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in
- Fig. 1:: eine schematische Längsansicht durch den Aktuator gemäß einer ersten bevorzugten Ausführungsform der Erfindung;
- Fig. 2:: eine Querschnittsansicht entlang der Schnittlinie A - B in Fig. 1;
- Fig. 3, Fig. 4:: Varianten zur Darstellung der Fig. 2 mit alternativen Querschnittsgeometrien der Flussleitelemente und
- Fig. 5:: eine schematische Längsschnittansicht analog Fig. 1 zum Verdeutlichen einer zweiten Ausführungsform der vorliegenden Erfindung.

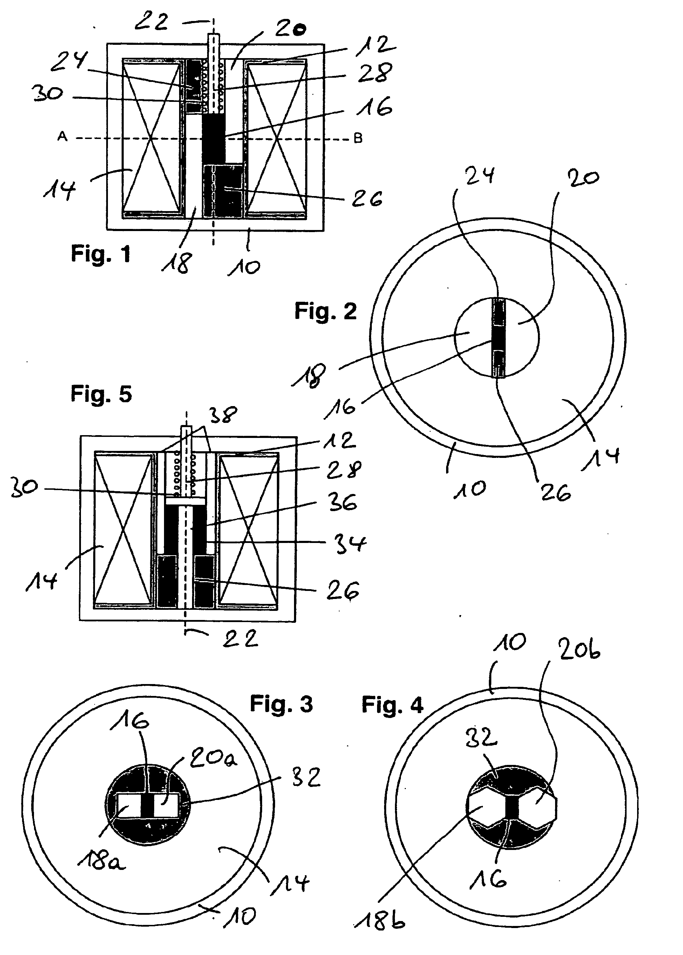

Die Fig. 1 zeigt im schematischen Längsschnitt, wie innerhalb eines (aus Vereinfachungsgründen einstückig gezeigten) hohlzylindrischen Gehäuses 10 aus magnetisch leitendem Material eine auf einem Spulenträger 12 gehaltene Spulenwicklung 14 ein Antriebselement 16 umschließt, welches aus einem Formgedächtnismaterial (MSM-Element bzw. MSMA-Element), typischerweise realisiert mit Hilfe einer NiMnGa-Legierung in ansonsten bekannter Weise, gebildet ist. Das Magnetfeld der Zylinderspule 14 wird über das Gehäuse 10 geführt zu einem Paar von magnetisch leitfähigen Flussleitelementen 18, 20, welche in der in Fig. 1 gezeigten Weise von einer Bodenwand bzw. Stirnwand (bezogen auf eine axiale Antriebsrichtung 22) langgestreckt abragen und zwischen ihren jeweiligen freien Endabschnitten das selbst langgestreckte, im Querschnitt rechteckförmige Formgedächtniselement 16 zwischen sich zum Herstellen eines magnetischen Flussübergangs einschließen.

Fig. 2 zeigt Details dieser geometrischen Anordnung in Querschnittsansicht entlang der Schnittebene A - B in Fig. 1: Es wird deutlich, dass innerhalb des zylindrischen Außengehäuses 10 und der Zylinderspule 14 das Paar von Flussleitelementen 18, 20 im Querschnitt kreissegmentförmig ist (so dass die langgestreckten Körper 18, 20 selbst zylinderabschnittsförmig sind), wobei die jeweiligen Flachseiten der Kreissegmente aufeinander gerichtet sind und zwischen sich das querschnittlich rechteckförmige Antriebselement 16 kontaktierend halten.

Wie wiederum günstig die Fig. 1 erkennen lässt, sind die Flussleitelemente zum Verschließen der Gehäusehohlräume umgeben von bzw. eingebettet in Materialbereiche 24, 26 aus magnetisch nicht leitendem Material (z.B. Kunststoff, welcher geeignet durch Spritzen oder andere Verfahren ausgeformt ist), wobei in herstellungstechnisch besonders günstiger Weise derartiges Kunststoffmaterial auch benutzt werden kann, um den Spulenträger 12 für die zylindrische Spulenwicklung 14 zu realisieren.

Wie zudem die Fig. 1 erkennen lässt, stützt sich das Antriebselement 16 ab gegen einen (nicht magnetisch leitenden) Materialabschnitt 26 und bildet axial gegenüberliegend ein Eingriffsende zum Zusammenwirken mit einer Stößeleinheit 28 als Stellpartner aus, welche in ansonsten bekannter Weise dann abtriebsseitig zur weiteren Übertragung der mechanischen Stellenergie kontaktiert sein kann.

Die Fig. 1 zeigt zudem eine im Gehäuse vorgesehene und gegen die Erstreckungsrichtung des Antriebselements 16 vorgespannte Druckfeder 30, welche als Rückstellelement wirkt und insbesondere die Aufgabe hat, das expandierte Antriebselement nach Beendigung der Magnetfeldbeaufschlagung wieder in seine ursprüngliche (kontrahierte) Position entgegengesetzt der Antriebsrichtung zurückzuführen.

Der Betrieb der anhand der Fig. 1 bzw. 2 gezeigten ersten Ausführungsform der vorliegenden Erfindung ist wie folgt: Als Reaktion auf eine Bestromung der Spulenwicklung 14 wird ein magnetischer Fluss erzeugt, der von den Flussleitelementen 18, 20 so an das Antriebselement 16 zum Schließen des magnetischen Kreises gebracht wird, dass der Magnetfluss durch das Element 16 in horizontaler Richtung (d.h. parallel zur Schnittlinie A - B und quer zur Antriebsachse 22) geführt wird. Dies ermöglicht, wie eingangs diskutiert, ein optimiertes Expansionsverhalten des Elements 16 als Reaktion auf die Magnetfeldbeaufschlagung, nicht zuletzt als, wie die Fig. 1 zeigt, beide Flussleitelemente 18, 20 entlang der Antriebsrichtung so ausgestaltet sind, dass diese die gesamte axiale Erstreckung des Antriebselements abdecken und insoweit für eine maximale magnetische Flusseintragung in das Antriebselement sorgen.

Die als Reaktion auf den magnetischen Fluss erzeugte Expansion des Antriebselements überträgt sich mechanisch auf den Stößel 28, welcher entsprechend der Expansion (ein typischer Wert sind ca. 5 % der axialen Gesamtlänge des Antriebselements) aus dem Gehäuse 10 herausbewegt wird und zur Ankopplung an einen externen Stellpartner bereitsteht. Nach Beendigung der Bestromung bewirkt die sich gegen die Gehäusestirnfläche abstützende Druckfeder 30 ein mechanisches Zurückführen des Antriebselements in die Ausgangsposition.

Die Fig. 3 und 4 verdeutlichen weitere Varianten von günstigen Querschnittsgeometrien der Flussleitelemente im Rahmen der Erfindung. Analog zur Darstellung gemäß Fig. 2 sieht etwa die Variante der Fig. 3 vor, dass die Flussleitelemente jeweils im Querschnitt rechteckig bzw. quadratisch in Form von Stäben 18a bzw. 20a ausgebildet sind und wiederum an den Flachseiten das Antriebselement 16 kontaktieren. Eine derartige Ausbildung dürfte insbesondere herstellungstechnisch günstig sein, da die Flussleitelemente, etwa als Stanzteile, günstig serientauglich herstellbar sind. Wiederum ist die Anordnung innerhalb der Zylinderspule 14 umspritzt von Kunststoffmaterial 32.

Wiederum alternativ sind die Flussleitelemente 18b bzw. 20b der Realisierungsform gemäß Fig. 4 im Querschnitt sechseckig, wobei wiederum eine jeweilige Flachseite gegenüberliegend das Formgedächtnismaterial 16 analog zur Darstellung der Fig. 1 kontaktiert.

Die Fig. 5 zeigt eine Variante zur vorbeschriebenen Ausführungsform, bei welcher das Antriebselement (hier Bezugszeichen 34) nicht als axial und mittig vorgesehener Körper ausgebildet ist, sondern als hohlzylindrisches Element, welches -- innerhalb eines ansonsten der Fig. 1 vergleichbaren Einbaukontext -- innenseitig kontaktiert wird von einem stiftförmigen ersten Flussleitelement 36 sowie mantelseitig außen von einem hülsenförmigen bzw. hohlzylindrischen zweiten Flussleitelement 38. Dementsprechend ist auch hier ein magnetischer Fluss quer zur Antriebsrichtung und Bewegungslängsachse 22 gewährleistet, wobei das Feld radial zwischen dem ersten Flussleitelement 36 und dem zweiten, umgebenden Flussleitelement 38, durch das zwischenliegende hohlzylindrische bzw. hülsenförmige Formgedächtnismaterial, verläuft.

Die vorliegende Erfindung ist nicht auf die gezeigten Ausführungsbeispiele beschränkt. So eignet sich beispielsweise jede beliebige Spulenform, und es ist nicht notwendigerweise eine wie in den Fig. gezeigte zylindrische Spulenform erforderlich (auch wenn dies, etwa im Hinblick auf existierende Einbauumgebungen für magnetische Aktuatoren, günstig ist). Auch ist bei den gezeigten Ausführungsbeispielen das Formgedächtnis-Antriebselement quaderförmig bzw. querschnittlich rechteckig realisiert, auch dies ist jedoch nicht notwendig, genauso wie, neben anderen geometrischen Realisierungen, auch mehrere Einzelelemente neben- oder übereinander angeordnet werden können und parallel bzw. in Reihe wirken.

## Patentansprüche

1. Aktuator mit einem als Reaktion auf eine elektrische Ansteuerung einer Spulenvorrichtung (14) antreibbaren Antriebselement (16) aus einem magnetischen Formgedächtnismaterial, welches zum Übertragen von mechanischer Antriebsenergie auf einem Stellpartner (28) ausgebildet ist, wobei dem als Expansionseinheit (16) ausgebildeten und sich entlang einer Antriebsrichtung (22) erstreckend ausgerichteten Antriebselement ein Paar von magnetischen Flussleitelementen (18, 20) für einen von der Spulenvorrichtung erzeugten Magnetfluss so seitlich benachbart zugeordnet ist, dass der Magnetfluss zwischen den Flussleitelementen durch die Expansionseinheit und quer zur Antriebsrichtung geführt ist,
und wobei die Spulenvorrichtung (14) umlaufend, insbesondere radial umlaufend um die sich axial in der Antriebsrichtung erstreckende Expansionseinheit (16) vorgesehen ist,
**dadurch gekennzeichnet, dass**
die Flussleitelemente des Paares von Flussleitelementen sich entlang der Antriebsrichtung von gegenüberliegenden Abschnitten eines magnetisch leitenden Spulengehäuses (10) erstreckend ausgebildet sind.

2. Aktuator nach Anspruch 1, **dadurch gekennzeichnet, dass** die Spulenvorrichtung eine innere Symmetrieachse ausbildet, die parallel zur Antriebsrichtung, insbesondere koaxial zu dieser, verläuft.

3. Aktuator nach Anspruch 1 oder 2, **dadurch gekennzeichnet, dass** mindestens eines des Paares von Flussleitelementen (18, 20) sich in der Antriebsrichtung entlang der Länge der Expansionseinheit erstreckt.

4. Aktuator nach einem der Ansprüche 1 bis 3, **dadurch gekennzeichnet, dass** die Expansionseinheit einen rechteckförmigen Querschnitt aufweist und an zwei einander gegenüberliegenden Mantelflächen mit dem Paar von Flussleitelementen (18, 20) kontaktiert ist.

5. Aktuator nach einem der Ansprüche 1 bis 4, **dadurch gekennzeichnet, dass** mindestens eines des Paares von Flussleitelementen zum Kontaktieren der Expansionseinheit eine plane Fläche ausbildet.

6. Aktuator nach einem der Ansprüche 1 bis 5, **dadurch gekennzeichnet, dass** mindestens eines des Paares von Flussleitelementen zumindest abschnittsweise querschnittlich eine Zylinderabschnitts- (18, 20), Rechteck- (18a, 20a) oder Vieleckform (18b, 20b) aufweist.

7. Aktuator nach einem der Ansprüche 1 bis 6, **dadurch gekennzeichnet, dass** mindestens eines des Paares von Flussleitelementen als sich in der Antriebsrichtung erstreckender Arm oder Armabschnitt ausgebildet ist.

8. Aktuator nach einem der Ansprüche 1 bis 7, **dadurch gekennzeichnet, dass** das Paar von magnetischen Flussleitelementen zumindest abschnittsweise in ein nicht magnetisches Material (24, 26) eingebettet ist, insbesondere von einem Kunststoffmaterial umspritzt ist.

9. Aktuator nach Anspruch 8, **dadurch gekennzeichnet, dass** das nicht magnetische Material einen Spulenträger (12) für die Spulenvorrichtung ausbildet.

10. Aktuator nach einem der Ansprüche 1 bis 9, **gekennzeichnet durch** ein axial zur Expansionseinheit angeordnetes und zum Ausüben einer Rückstellkraft auf dieses ausgebildetes Rückstellelement (30), insbesondere Rückstellfeder.

11. Aktuator nach einem der Ansprüche 1 bis 10, **dadurch gekennzeichnet, dass** die Expansionseinheit als hohlzylindrischer Körper (34) aus dem magnetischen Formgedächtnismaterial gebildet ist, der mantelseitig mit einem ersten, insbesondere hohlzylindrisch ausgebildeten Flussleitelement (38) des Paares von magnetischen Flussleitelementen sowie innenseitig mit einem stiftförmigen zweiten Flussleitelement (36) des Paares von Flussleitelementen zusammenwirkt

## Claims

1. An actuator with a drive element (16) of a magnetic shape memory material, which drive element is designed so as to transfer mechanical drive energy to an actuating partner (28), and can be driven in reaction to an electrical activation of a coil device (14), wherein
a pair of magnetic flux conducting elements (18, 20), for a magnetic flux generated by the coil device, are assigned laterally adjacent to the drive element, which is designed as an expansion unit (16) and is aligned extending along a drive direction (22), such that the magnetic flux between the flux conducting elements is led through the expansion unit and transverse to the drive direction, and wherein
the coil device (14) is provided circumferentially around, in particular radially circumferentially around, the expansion unit (16), which extends axially in the drive direction,
**characterised in that**,
the flux conducting elements of the pair of flux conducting elements are designed such that they extend in the drive direction along opposite sections of a magnetically conducting coil housing (10).

2. The actuator in accordance with Claim 1,
**characterised in that**,
the coil device forms an internal axis of symmetry, which runs parallel to the drive direction, in particular coaxially with the latter.

3. The actuator in accordance with Claim 1 or 2,
**characterised in that**,
at least one of the pair of flux conducting elements (18, 20) extends in the drive direction along the length of the expansion unit.

4. The actuator in accordance with one of the Claims 1 to 3,
**characterised in that**,
the expansion unit has a rectangular cross-section, and is in magnetic contact with the pair of flux conducting elements (18, 20) on two opposing sleeve surfaces.

5. The actuator in accordance with one of the Claims 1 to 4,
**characterised in that**,
at least one of the pair of flux conducting elements forms a plane surface for purposes of establishing magnetic contact with the expansion unit.

6. The actuator in accordance with one of the Claims 1 to 5,
**characterised in that**,
at least one of the pair of flux conducting elements has at least sectionally a cylindrical segmental shape (18, 20), a rectangular shape (18a, 20a) or a polygonal shape (18b, 20b).

7. The actuator in accordance with one of the Claims 1 to 6,
**characterised in that**,
at least one of the pair of flux conducting elements is designed as an arm or an arm section extending in the drive direction.

8. The actuator in accordance with one of the Claims 1 to 7,
**characterised in that**,
the pair of magnetic flux conducting elements are at least sectionally embedded in a non-magnetic material (24, 26), in particular are coated with an injected plastic material.

9. The actuator in accordance with Claim 8,
**characterised in that**,
the non-magnetic material forms a coil support (12) for the coil device.

10. The actuator in accordance with one of the Claims 1 to 9,
**characterised by**
a restoring element (30), in particular a restoring spring, arranged axially with respect to the expansion unit, and designed so as to exert a restoring force on the latter.

11. The actuator in accordance with one of the Claims 1 to 10,
**characterised in that**,
the expansion unit is designed as a hollow cylindrical body (34) of the magnetic shape memory material, which interacts on the sleeve side with a first flux conducting element (38), in particular of hollow cylindrical design, of the pair of magnetic flux conducting elements, and interacts internally with a pin-shaped second flux conducting element (36) of the pair of flux conducting elements.

## Revendications

1. Actionneur doté d'un élément d'entraînement (16) pouvant être entraîné en réaction sur une commande électrique d'un dispositif de bobines (14), ledit élément étant composé d'un matériau à mémoire de forme magnétique réalisé pour transmettre l'énergie d'entraînement mécanique sur un partenaire de réglage (28) ; une paire d'éléments de conduction de flux (18, 20) magnétiques, prévus pour un flux magnétique produit par le dispositif de bobines, étant associée de telle sorte adjacent à l'élément d'entraînement prenant la forme d'une unité d'expansion (16) et s'étendant le long d'une direction d'entraînement (22) que le flux magnétique est guidé entre les éléments de conduction de flux par l'unité d'expansion et transversalement à la direction d'entraînement ; et le dispositif de bobines (14) étant prévu de façon à circuler, notamment de façon à circuler dans le plan radial, autour de l'unité d'expansion (16) s'étendant dans le plan axial dans la direction d'entraînement ;
**caractérisé en ce que** :
les éléments de conduction de flux de la paire étant réalisés de façon à s'étendre le long de la direction d'entraînement à partir de sections opposées d'un carter de bobines (10) magnétiquement conducteur.

2. Actionneur selon la revendication 1, **caractérisé en ce que** le dispositif de bobines forme un axe de symétrique intérieur s'étendant parallèlement à la direction d'entraînement, notamment dans le plan coaxial par rapport à celle-ci.

3. Actionneur selon la revendication 1 ou 2, **caractérisé en ce qu'**au moins un des éléments de la paire d'éléments de conduction de flux (18, 20) s'étend dans la direction d'entraînement le long de la longueur de l'unité d'expansion.

4. Actionneur selon l'une quelconque des revendications 1 à 3, **caractérisé en ce que** l'unité d'expansion comporte une section transversale en forme de rectangle et est contactée au niveau des deux surfaces d'enveloppe opposées l'une par rapport à l'autre par la paire d'éléments de conduction de flux (18, 20).

5. Actionneur selon l'une quelconque des revendications 1 à 4, **caractérisé en ce qu'**au moins un élément de la paire d'éléments de conduction de flux forme une surface plane pour réaliser la mise en contact de l'unité d'expansion.

6. Actionneur selon l'une quelconque des revendications 1 à 5, **caractérisé en ce qu'**au moins un élément de la paire d'éléments de conduction de flux prend au moins en partie en section transversale une forme de section cylindrique (18, 20), de rectangle (18a, 20a) ou de carré (18b, 20b).

7. Actionneur selon l'une quelconque des revendications 1 à 6, **caractérisé en ce qu'**au moins un élément de la paire d'éléments de conduction de flux prend la forme d'un bras ou d'une section de bras s'étendant dans la direction d'entraînement.

8. Actionneur selon l'une quelconque des revendications 1 à 7, **caractérisé en ce que** la paire d'éléments de conduction de flux magnétique est logée au moins en partie dans une matière (24, 26) non magnétique, notamment entourée d'une injection de matière plastique.

9. Actionneur selon la revendication 8, **caractérisé en ce que** la matière non magnétique forme un support de bobines (12) pour le dispositif de bobines.

10. Actionneur selon l'une quelconque des revendications 1 à 9, **caractérisé par** la présence d'un élément de rappel (30), notamment d'un ressort de rappel, disposé dans le plan axial par rapport à l'unité d'expansion et réalisé sur celui-ci pour exercer une force de rappel.

11. Actionneur selon l'une quelconque des revendications 1 à 10, **caractérisé en ce que** l'unité d'expansion prend la forme d'un corps (34) cylindrique creux en matériau à mémoire de forme magnétique qui interagit du côté d'enveloppe avec un premier élément de conduction de flux (38), notamment réalisé à la façon d'un cylindre creux, de la paire d'éléments de conduction de flux magnétique ainsi que du côté intérieur avec un deuxième élément de conduction de flux (36), en forme de tige, de la paire d'éléments de conduction de flux.
